# EUROPÄISCHE PATENTSCHRIFT

(11) **EP 4 176 275 B1**
(45) Veröffentlichungstag und Bekanntmachung des Hinweises auf die Patenterteilung: **31.12.2025**
(21) Anmeldenummer: 21761975.8
(22) Anmeldetag: 27.07.2021
(51) Int. Cl.: G01R 31/28

(54) **KALIBRIERUNGSANORDNUNG UND ENTSPRECHENDES KALIBRIERUNGSVERFAHREN SOWIE KALIBRIERUNGSVORRICHTUNG**
CALIBRATION ARRANGEMENT AND CORRESPONDING CALIBRATION METHOD, AND CALIBRATION APPARATUS
ENSEMBLE D'ÉTALONNAGE ET PROCÉDÉ D'ÉTALONNAGE CORRESPONDANT AINSI QUE DISPOSITIF D'ÉTALONNAGE

(30) Priorität: 29.07.2020 DE 102020209549
(43) Veröffentlichungstag der Anmeldung: 10.05.2023
(73) Patentinhaber: ERS electronic GmbH, 82110 Germering (DE)
(72) Erfinder: REITINGER, Klemens, 82110 Germering (DE)
(74) Vertreter: Isarpatent
(86) Internationale Anmeldenummer: PCT/EP2021/070991
(87) Internationale Veröffentlichungsnummer: WO 2022/023336

(56) Entgegenhaltungen:
- EP-A1- 3 030 914
- US-A- 6 124 793
- US-A1- 2008 018 352
- US-A1- 2009 096 475

## Beschreibung

Die vorliegende Erfindung betrifft eine Kalibrierungsanordnung und ein entsprechendes Kalibrierungsverfahren zum Kalibrieren eines in einem Waferprober angeordneten Chucks.

Heutzutage werden Funktionsprüfungen von in einem Wafer integrierten Schaltungen (Mikrochips) auf einem temperierbaren Chuck in einem Waferprober zwischen - 60°C und +300°C in immer größeren Umfang durchgeführt.

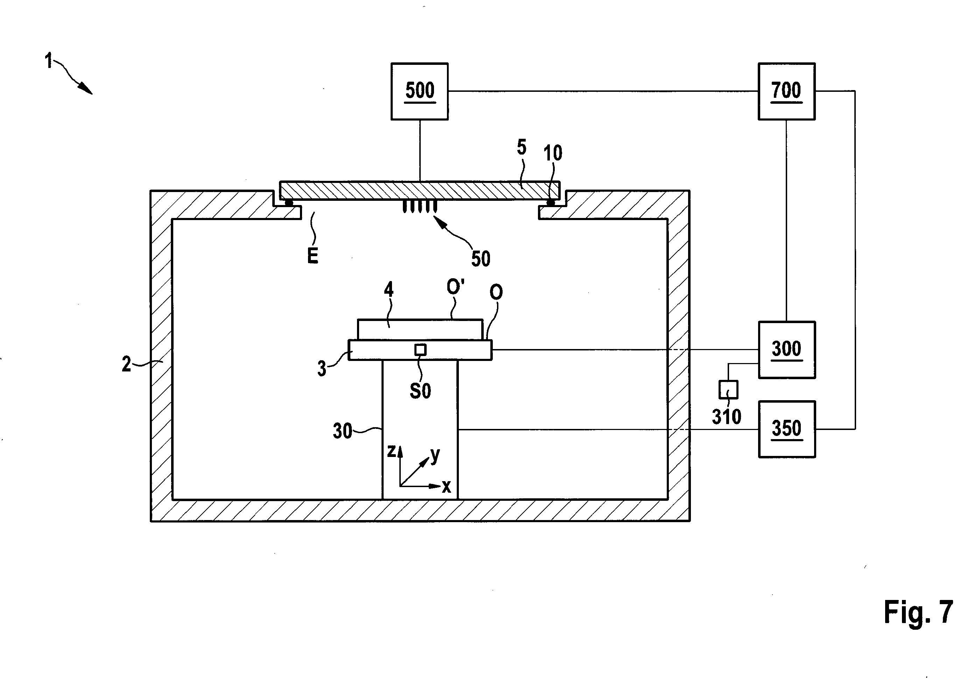

Fig. 7 zeigt eine beispielhafte Waferproberanordnung.

In Fig. 7 bezeichnet Bezugszeichen 1 einen Waferprober, welcher ein Gehäuse 2 mit einer Einsetzöffnung E zum lösbaren Einsetzen einer Testkarte 5 aufweist. Die Testkarte 5 ist beispielsweise mittels einer Dichteinrichtung 10 gegenüber dem Gehäuse 2 abgedichtet, sodass bei eingesetzter Testkarte 5 ein im Wesentlichen geschlossener Raum im Waferprober 1 gebildet ist. Die Testkarte 5 weist eine Mehrzahl von Testsonden 50 (Testnadeln) zum Testen von auf einem bzw. an der Oberseite O' von einem Wafer 4 befindlichen integrierten Schaltungen (nicht dargestellt) auf.

Angeordnet im Raum 2 ist ein temperierter Chuck 3 zum Aufspannen des Wafers 4 auf dessen Oberseite O, welcher mittels eines Positionscontrollers 350 über eine Verstelleinrichtung 30 in seitlichen Richtungen x, y und in Höhenrichtung z verfahrbar ist. Die Richtungen x, y, z bilden im vorliegenden Fall ein orthogonales kartesisches Koordinatensystem.

Über einen Temperaturcontroller 300 ist der Chuck 3 auf eine eingebbare Solltemperatur mittels einer (nicht dargestellten) Heizeinrichtung und einer (nicht dargestellten) Kühleinrichtung temperierbar. Insbesondere dient die Kühleinrichtung zum Erzielen von Temperaturen unterhalb der Raumtemperatur. Im Chuck 3 angeordnet ist eine Temperatursonde S0 zum Erfassen und Ausgeben einer aktuellen Chucktemperatur, wobei die Ausgabewerte an den Temperaturcontroller 300 geleitet und von einer damit verbundenen Ausgabeeinrichtung 310, z.B. ein Display, angezeigt werden. Die Temperatursonde S0 kann ebenfalls vom Temperaturcontroller 300 zur Temperaturregelung verwendet werden.

Bezugszeichen 700 bezeichnet einen Probercontroller, welcher mit dem Temperaturcontroller 300, dem Positionscontroller 350 und einem Testcontroller 500 verbunden ist. Der Testcontroller dient zur Ansteuerung der Testsonden 50 (Testnadeln).

Über den Probercontroller 700 und den Testcontroller 500 lassen sich Testprogramme durchführen, gemäß denen der Testcontroller 500 die Testsonden 50 mit entsprechenden Testleistungen ansteuert. Weiterhin lassen sich über den Probercontroller 700 die jeweilige Solltemperatur des Temperaturcontrollers 300 und die jeweilige Sollposition des Positionscontrollers 350 vorgeben. Die entsprechenden Verbindungslinien zwischen den Komponenten 5, 500, 700, 300, 310, 3 und 350 sind beispielsweise über entsprechende Busleitungen und/oder Analogleitungen etabliert.

Bis jetzt lag die erreichbare Temperaturgenauigkeit der lokalen Chucktemperatur an der jeweiligen integrierten Schaltung in der Größenordnung von ca. 2°C oder darüber. Neue Technologien erfordern jedoch eine höhere Temperaturgenauigkeit bis zu 0,1 °C oder darunter. Derartige Temperaturgenauigkeiten kann man nur durch Kalibrierung des verwendeten Testaufbaus (Chuck, Waferprober, Testkarte) erreichen.

Die derzeit gebräuchlichste Methode hierfür ist ein sogenannter Messwafer. In diesem (Standard-Silizium-) Messwafer ist eine Vielzahl von Temperatursensoren eingearbeitet (meist zwischen 13 und 17 Stück). Diese Temperatursensoren sind mit einem Auswertegerät verbunden. Die Temperatursonden können somit kalibriert werden. Der Messwafer wird auf den Chuck aufgelegt, und die Temperaturgenauigkeit und Temperaturverteilung werden angezeigt.

Eine andere Methode ist das Auflegen eines einzelnen Sensors (Dropsensor) an verschiedenen Temperatur-Messpunkten. Die ermittelten Werte werden dann (üblicherweise manuell) in Kompensationstabellen des Temperaturcontrollers eingepflegt.

Die Nachteile des Messwafers sind eine Einschränkung der Genauigkeit durch das Vorhandensein mehrerer Sensoren bzw. Sonden und deren Abweichung untereinander. Ebenso ist ein derartiger Messwafer zudem üblicherweise sehr teuer.

Die Nachteile des Dropsensors sind der Zeitaufwand beim Messen sowie die Ungenauigkeit beim Anbringen des Dropsensors auf der zu vermessenden Oberfläche des Chucks.

Der Hauptnachteil beider Verfahren (und auch aller anderer soweit bekannter Verfahren) ist jedoch, dass die Genauigkeit der Chucktemperatur unter anderen Umgebungseinflüssen festgestellt wird als denen des eigentlichen Tests der Chips. Meistens wird der Wafer weit entfernt vom Kalibrierungsort auf den Chuck gelegt, und auch ein Dropsensor kann nicht an der späteren Messstelle angewendet werden.

Das bedeutet, dass eigentlich niemals genau festgestellt werden kann, welche Temperatur an welcher Stelle genau während des Probens der Mikrochips genau unter dem zu testenden Mikrochip anliegt. Das genau ist aber der Temperaturwert, der während des Tests benötigt wird. Bis jetzt war es genau genug anzunehmen, dass sich dieser Wert von dem mit dem Messwafer festgestellten Wert wohl nicht so stark unterscheiden wird. In der heute geforderten Genauigkeit genügt das jedoch nicht mehr.

Aus der DE 10 2009 030 471 A1 sind ein Kalibrierungsverfahren zum Kalibrieren eines Chucks sowie eine entsprechende Kalibrierungsvorrichtung bekannt. Vorgesehen ist ein Chuck zur Aufnahme und Halterung eines Testsubstrats mit einer Vorrichtung zur Aufnahme und Halterung eines Kalibriersubstrats. Der Chuck umfasst eine erste Aufnahmefläche zur Aufnahme des Testsubstrats und eine zweite, zur ersten seitlich versetzte Aufnahmefläche zur Aufnahme des Kalibriersubstrats, wobei das Kalibriersubstrat planare Kalibrierstandards zur Kalibrierung einer Messeinheit eines Waferprobers aufweist und unterhalb des Kalibriersubstrats zumindest im Bereich der Kalibrierstandards dielektrisches Material oder Luft angeordnet ist. Um die tatsächlichen thermischen Verhältnisse am Testsubstrat und insbesondere auch an den bekannten sowie unbekannten Kalibrierstandards und damit den thermischen Einfluss auf das elektrische Verhalten der verwendeten Kalibrierstandards berücksichtigen zu können, wird vorgeschlagen, die zweite Aufnahmefläche mit Mitteln zur Temperierung des Kalibriersubstrats auszustatten.

Die US 6 124 793 A offenbart eine Kalibrierungsanordnung zum Kalibrieren eines Chucks mit einem von einem Temperatrurcontroller auf eine eingebbare Solltemperatur temperierbaren Chuck zum Aufspannen eines Wafers, einer im Chuck angeordneten Temperaturerfassungseinrichtung mit einer oder mehreren Temperatursonden zum Erfassen und Ausgeben einer jeweiligen aktuellen Chucktemperatur an der Position der jeweiligen Temperatursonde und einer Kalibrierungsvorrichtung aufweisend eine Auswerteeinrichtung.

Die US 2009/096475 A und die US 2008/018352 A1 offenbaren einen Waferprober mit einer Einsetzöffnung zum Einsetzen einer Testkarte, wobei der Chuck mittels eines Positionscontrollers über eine Verstelleinrichtung in seitlichen Richtungen und in einer Höhenrichtung verfahrbar ist.

Die EP 3 030 914 A1 offenbart eine thermische Abschirmvorrichtung mit einem Temparatursensor zur Vermeidung einer asymetrischen Temperaturverteilung auf einer Testkarte.

Die vorliegende Erfindung schafft eine Kalibrierungsanordnung nach Anspruch 1 und entsprechendes Kalibrierungsverfahren nach Anspruch 12.

Bevorzugte Weiterbildungen sind Gegenstand der jeweiligen abhängigen Ansprüche.

Die der vorliegenden Erfindung zugrundeliegende Idee besteht darin, eine Kalibrierungsvorrichtung vorzusehen, welche eine in oder an einer Einsetzöffnung für eine Testkarte eines Waferprobers anbringbare oder darin integrierte Kalibrierungskarte aufweist, wobei bei angebrachter Kalibrierungskarte ein entsprechender im Wesentlichen geschlossener Raum wie bei eingesetzter Testkarte gebildet ist.

Die Kalibrierungsvorrichtung weist eine an der Kalibrierungskarte angebrachte Kalibrierungstemperatursonde auf, welche vom Chuck mittels des Positionscontrollers des Chucks derart anfahrbar ist, dass die Kalibrierungstemperatursonde eine jeweilige aktuelle Temperatur an verschiedenen Positionen an der Oberfläche des Chucks oder an der Oberfläche eines darauf aufgespannten Wafers erfassen kann.

Die Kalibrierungsvorrichtung weist weiterhin eine Auswerteeinrichtung auf, welche mit der Kalibrierungstemperatursonde, dem Temperaturcontroller und dem Positionscontroller verbindbar ist und welche eingerichtet ist, die Temperaturausgabewerte der einen oder der mehreren Temperatursonden anhand den von der Kalibrierungstemperatursonde erfassten aktuellen Temperaturen an den verschiedenen Positionen zu kalibrieren.

Vorteilhafterweise kann so die Chucktemperatur genau unter den gleichen Umgebungsbedingungen geprüft, unter welchen der Mikrochip später tatsächlich gemessen wird. Die Temperatursonden im Chuck können ohne Ausbau kalibriert werden, wobei die Kalibrierungstemperatursonde einfach und unabhängig von den Temperatursonden im Chuck kalibriert werden kann. Der Herstellungsaufwand ist deutlich geringer als derjenige eines bekannten Messwafers. Die manuellen Wiederholungsfehler der Dropsensor-Methode können durch den automatischen, maschinellen Kontaktierungsprozess ausgeschlossen werden. Die Verbindung aller Komponenten mit der geeigneten Software ermöglicht ein vollautomatisches Kalibrieren. Die kalibrierten Temperatursonden im Chuck ermöglichen eine permanente Überwachung der Temperaturverteilung während der Tests. Ebenso ermöglichen es diese Temperatursonden im Chuck, exakt die Chucktemperatur an den Waferprober zurückzumelden, die sich unter dem jeweiligen Chip befindet, der in dem jeweiligen Temperaturerfassungssektor getestet wird.

Die vorliegende Erfindung ermöglicht somit eine vollständige, lagebezogene Kalibrierung eines Chucks sowie eine wiederholte Überprüfung dieser Werte durch eine erneute Kalibrierung. Durch den robusten Aufbau ist sie industrietauglich, durch die verwendeten Komponenten wirtschaftlich.

Gemäß einer weiteren bevorzugten Weiterbildung weist die Temperaturerfassungseinrichtung eine einzige Temperatursonde auf, wobei die die Auswerteeinrichtung eingerichtet ist, die Temperaturausgabewerte der einzigen Temperatursonde anhand von der Kalibrierungstemperatursonde erfassten aktuellen Temperaturen an den verschiedenen Positionen zu kalibrieren. Dies ermöglicht einen besonders einfachen Aufbau.

Gemäß einer weiteren bevorzugten Ausführungsform weist die Temperaturerfassungseinrichtung mehrere Temperatursonden auf, wobei jeder Temperatorsonde ein Temperaturerfassungssektor im Chuck zugeordnet ist, für den sie die jeweilige aktuelle Chucktemperatur erfasst und ausgibt, und wobei die Auswerteeinrichtung eingerichtet ist, die Temperaturausgabewerte der jeweiligen Temperatursonde anhand der von der Kalibrierungstemperatursonde erfassten aktuellen Temperaturen für den zugeordneten Temperaturerfassungssektor zu kalibrieren. So lassen sich die lokalen Chucktemperaturen besonders genau erfassen.

Gemäß einer weiteren bevorzugten Ausführungsform weist der Temperaturcontroller eine Speichereinrichtung auf, wobei die Auswerteeinrichtung eingerichtet ist, die kalibrierten Temperaturausgabewerte der einen oder der mehreren Temperatursonden an den verschiedenen Positionen in der Speichereinrichtung zu speichern.

Gemäß einer weiteren bevorzugten Ausführungsform weist der Temperaturcontroller eine Ausgabeeinrichtung, insbesondere eine Anzeigeeinrichtung, zum Ausgeben der kalibrierten Temperaturausgabewerte der einen oder der mehreren Temperatursonden an den verschiedenen Positionen auf.

Gemäß einer weiteren bevorzugten Ausführungsform weist die Kalibrierungstemperatursonde einen durch die Kalibrierungskarte geführten Schaft auf, an dessen Ende ein Thermowiderstand, vorzugsweise ein Pt100-Thermowiderstand, angebracht ist.

Gemäß einer weiteren bevorzugten Ausführungsform weist die Kalibrierungstemperatursonde einen kontaktlosen Infrarotsensor auf. Dies vermeidet einen direkten Oberflächenkontakt.

Gemäß einer weiteren bevorzugten Ausführungsform weist die Kalibrierungstemperatursonde eine Messgenauigkeit im Bereich von 1 mK bis 10 mK auf, insbesondere im Bereich von 1 mK bis 5 mK, und/oder weist die Kalibrierungstemperatursonde einen Flächenerfassungsbereich im Bereich 10 mm² bis 20 mm² auf. Dies ermöglicht eine hochpräzise Erfassung der Chucktemperatur.

Gemäß einer weiteren bevorzugten Ausführungsform ist der Temperaturcontroller eingerichtet, die Solltemperatur mittels mindestens einer der kalibrierten Temperatursonden zu regeln. Dies erspart die Notwendigkeit einer separaten Regelungssonde und liefert präzise Regelungswerte.

Gemäß einer weiteren bevorzugten Ausführungsform ist die Kalibrierungskarte einteilig integriert mit der Testkarte ausgebildet. Somit enthält ein und dieselbe Karte die Kalibrierungstemperatursonde und die Testsonden, und ein Kartenwechsel ist nicht mehr notwendig.

Gemäß einer weiteren bevorzugten Ausführungsform weist die Kalibrierungstemperatursonde einen höhenverstellbar durch die Kalibrierungskarte geführten Schaft auf. So lassen sich Interferenzen von der Kalibrierungstemperatursonde und den Testsonden vermeiden.

Ausführungsbeispiele der Erfindung sind in den Zeichnungen dargestellt und in der nachfolgenden Beschreibung näher erläutert.

Es zeigen:
- Fig. 1a): eine Kalibrierungsanordnung gemäß einer ersten Ausführungsform der vorliegenden Erfindung im Ausgangszustand;
- Fig. 1b): die Kalibrierungsanordnung gemäß der ersten Ausführungsform der vorliegenden Erfindung im Kalibrierungszustand;
- Fig. 2: eine schematische ebene Querschnittsansicht des Chucks der ersten Ausführungsform;
- Fig. 3: ein Kalibrierungsverfahren gemäß einer zweiten Ausführungsform der vorliegenden Erfindung;
- Fig. 4: eine Kalibrierungsanordnung gemäß einer dritten Ausführungsform der vorliegenden Erfindung im Ausgangszustand;
- Fig. 5: eine Kalibrierungsanordnung gemäß einer vierten Ausführungsform der vorliegenden Erfindung im Ausgangszustand;
- Fig. 6: eine Kalibrierungsanordnung gemäß einer fünften Ausführungsform der vorliegenden Erfindung im Ausgangszustand; und
- Fig. 7: eine beispielhafte Waferproberanordnung.

In den Figuren bezeichnen gleiche Bezugszeichen gleiche oder funktionsgleiche Bestandteile.

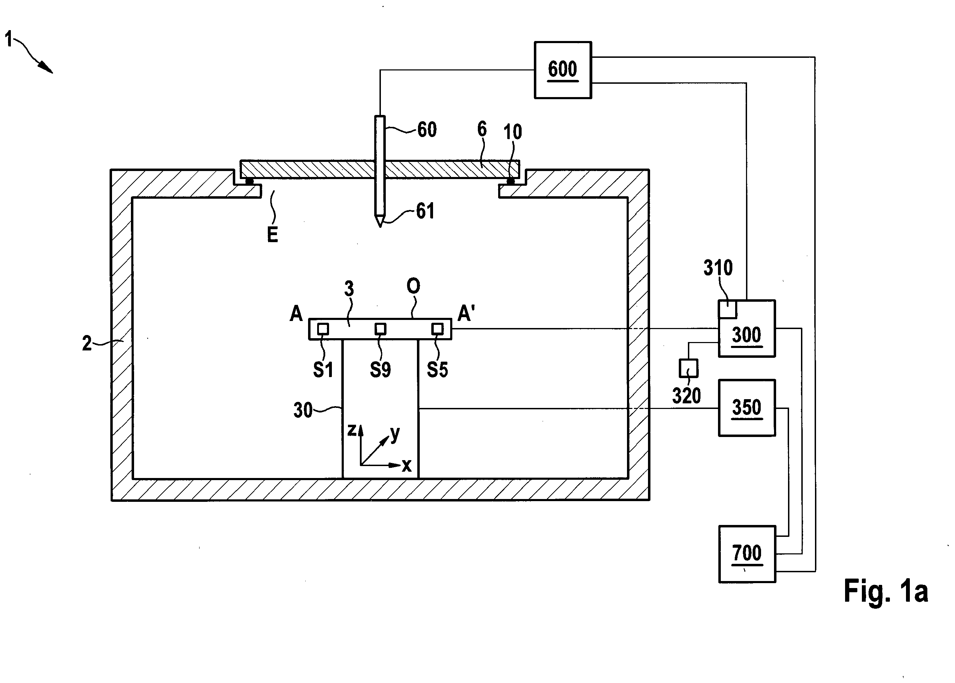

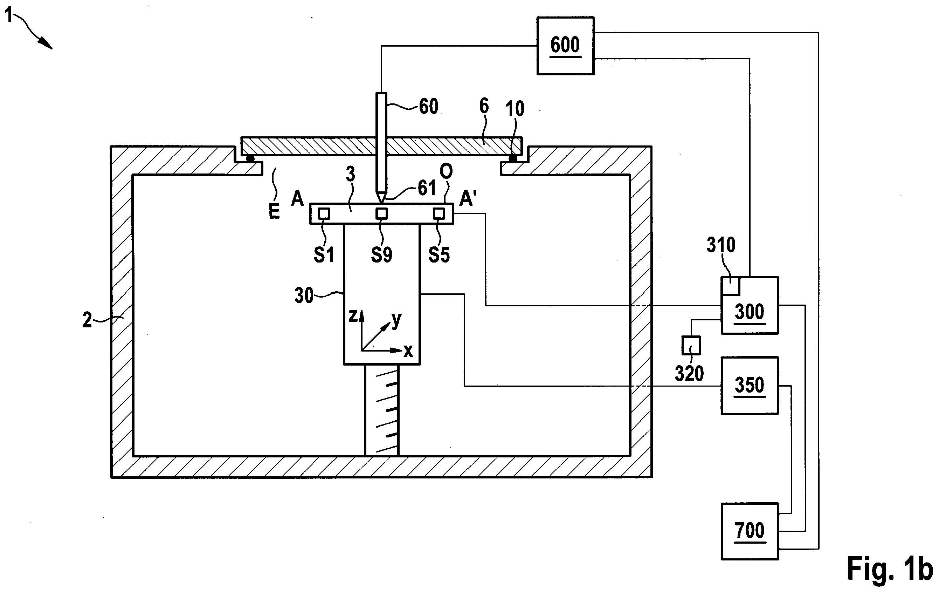

Fig. 1a) zeigt eine Kalibrierungsanordnung gemäß einer ersten Ausführungsform der vorliegenden Erfindung im Ausgangszustand vor der Kalibrierung, und Fig. 1b) die Kalibrierungsanordnung gemäß der ersten Ausführungsform der vorliegenden Erfindung im Kalibrierungszustand bei der Kalibrierung.

Die in Fig. 1a), b) gezeigte Darstellung der Kalibrierungsanordnung gemäß der ersten Ausführungsform ist analog zum Waferprober 1 gemäß Fig. 7 aufgebaut, wobei anstelle der Testkarte 5 mit den Testsonden 50 eine Kalibrierungskarte 6 in der Einsetzöffnung E angebracht ist. Zudem wurde der Testcontroller 500 nicht dargestellt, da er zur Kalibrierung nicht benötigt wird.

Die Kalibrierungskarte 6 ist beispielsweise ebenfalls über die Dichteinrichtung 10 gegenüber dem Behälter 2 abgedichtet, sodass bei angebrachter Kalibrierungskarte 6 ein entsprechender im Wesentlichen geschlossener Raum gebildet ist.

Bei anderen, nicht dargestellten Ausführungsformen ist es ebenfalls möglich, dass die Kalibrierungskarte 6 an der Einsetzöffnung E seitlich beabstandet von der Einsetzöffnung E aufgesetzt und abgedichtet ist.

Je nach Ausgestaltung der Kalibrierungskarte 6 kann die Größe des entsprechenden geschlossenen Raumes geringfügig gegenüber der Größe des geschlossenen Raumes bei eingesetzter Testkarte 5 variieren, was jedoch für die Umgebungsbedingungen des Chucks 3 beim Kalibrieren irrelevant ist, so dass diese Umgebungsbedingungen den Umgebungsbedingungen beim Testen entsprechen.

An der Kalibrierungskarte 6 ist eine Kalibrierungstemperatursonde 60, 61 angebracht, welche vom Chuck 3 mittels des Positionscontrollers 300 in einem Kalibrierungsmodus derart anfahrbar ist, dass die Kalibrierungstemperatursonde 60, 61 eine jeweilige aktuelle Temperatur an verschiedenen Positionen an der Oberfläche O des Chucks 3 erfassen kann.

Die Kalibrierungstemperatursonde 60, 61 weist bei der ersten Ausführungsform einen durch die Kalibrierungskarte 6 geführten Schaft 60 auf, an dessen im Raum 2 befindlichen Ende ein Thermowiderstand 61 in Form eines Pt100-Thermo-widerstands, z.B. federnd, angebracht ist.

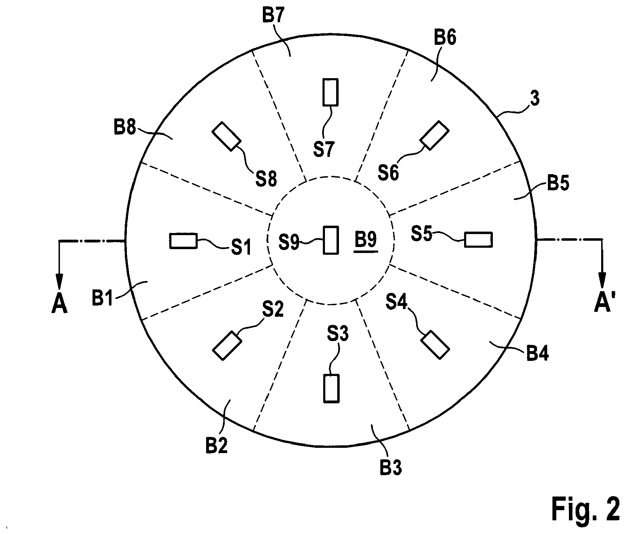

Die Kalibrierungstemperatursonde 60, 61 ist mit einer Auswerteeinrichtung 600 verbunden, welche ebenfalls mit dem Temperaturcontroller 300 und dem Probercontroller 700 verbunden ist. Die Auswerteeinrichtung 600 ist eingerichtet, die Temperaturausgabewerte einer Mehrzahl von Temperatursonden S1 bis S9, welche bei dieser Ausführungsform anstelle der einzigen Temperatursonde S0 im Chuck 3 angeordnet sind (vgl. Fig. 2), anhand den von der Kalibrierungstemperatursonde 60, 61 erfassten aktuellen Temperaturen an den verschiedenen Positionen zu kalibrieren. Der entsprechende Kalibrierungsmodus ist wie die Testmodi von dem Probercontroller 700 steuerbar bzw. eingebbar, welcher analog zu Fig. 7 über eine Netzwerkverbindung und/oder Analogverbindung mit der Auswerteeinrichtung 600 verbunden ist, wie auch die Auswerteeinrichtung 600 mit dem Temperaturcontroller 300 verbunden ist.

Der Temperaturcontroller 300 weist zudem eine nicht-flüchtige Speichereinrichtung 310 auf, in der die kalibrierten Temperaturausgabewerte der Temperatursonden S1 bis S9 an den verschiedenen Positionen auf dem Chuck 3 speicherbar sind.

Fig. 2 zeigt eine schematische ebene Querschnittsansicht des Chucks der ersten Ausführungsform entlang der Linie A-A' in Fig. 1a), b).

Fig. 2 zeigt die Anordnung der Temperatursonden S1 bis S9 im Chuck 3. Jeder Temperatursonde S1 bis S9 ist ein entsprechender Temperaturerfassungssektor B1 bis B9 im Chuck 3 zugeordnet, für den sie die jeweilige aktuelle Chucktemperatur erfasst und ausgibt. Die Ausgabeeinrichtung 600 ist eingerichtet, die Temperaturausgabewerte der jeweiligen Temperatursonde S1 bis S9 anhand der von der Kalibrierungstemperatursonde 60, 61 erfassten aktuellen Temperaturen für den zugeordneten Temperaturerfassungssektor B1 bis B9 zu kalibrieren und in der Speichereinrichtung 310 des Temperaturcontrollers 300 zu speichern.

Die Regelung der eingegebenen Solltemperatur durch den Temperaturcontroller 300 erfolgt entweder mittels einer (nicht dargestellten) Regelungssonde oder mittels einer oder mehrerer der kalibrierten Temperatursensoren S1 bis S9. Dabei ist es möglich, dass die Regelung in jedem der Temperaturerfassungssektoren B1 bis B9 mit der jeweiligen zugeordneten Temperatursonde S1 bis S9 erfolgt. Eine andere Möglichkeit der Regelung besteht darin, sie auf einen Mittelwert aller oder lediglich der benachbarten Temperatursensoren S1 bis S9 gerichtet durchzuführen.

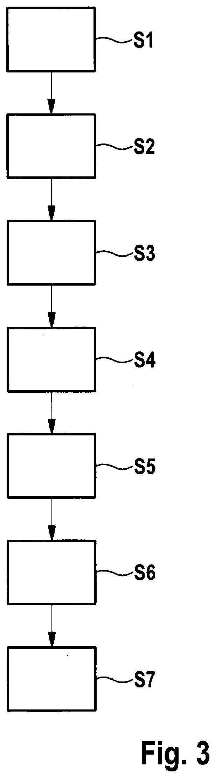

Fig. 3 zeigt ein Kalibrierungsverfahren gemäß einer zweiten Ausführungsform der vorliegenden Erfindung.

Bei dem Kalibrierungsverfahren gemäß Fig. 3 erfolgt im Schritt S1 das Bereitstellen von dem Waferprober 1 mit der Einsetzöffnung E zum Einsetzen der Testkarte 5 mit den Testsonden 50 zum Testen von auf dem Wafer 4 befindlichen integrierten Schaltungen, wobei bei eingesetzter Testkarte 5 der im Wesentlichen geschlossener Raum gebildet ist.

In Schritt S2 erfolgt das Bereitstellen von dem vom Temperaturcontroller 300 auf eine eingebbare Solltemperatur temperierbaren Chuck 3 zum Aufspannen des Wafers 4, wobei der Chuck 3 mittels des Positionscontrollers 350 in den seitlichen Richtungen x, y und in der Höhenrichtung z verfahrbar ist.

In Schritt S3 erfolgt das Bereitstellen von der im Chuck 3 angeordneten Temperaturerfassungseinrichtung mit der eine oder den mehreren Temperatursonden S1-S9 zum Erfassen und Ausgeben der jeweiligen aktuellen Chucktemperatur an der Position der jeweiligen Temperatursonde S1-S9.

In Schritt S4 erfolgt das Anbringen der Kalibrierungskarte 6 in oder an der Einsetzöffnung E, wobei bei angebrachter Kalibrierungskarte 6 ein entsprechender im Wesentlichen geschlossener Raum gebildet ist, wobei an der Kalibrierungskarte 6 die Kalibrierungstemperatursonde 60, 61 angebracht ist.

Im Schritt S5 erfolgt das Anfahren der Kalibrierungstemperatursonde 60, 61 vom Chuck 3 mittels des Positionscontrollers 350 und Erfassen der jeweiligen aktuellen Temperatur an verschiedenen Positionen an der Oberfläche O des Chucks 3 mittels der Kalibrierungstemperatursonde 60, 61.

In Schritt S6 erfolgt das Kalibrieren der Temperaturausgabewerte der einen oder der mehreren Temperatursonden S1-S9 anhand den von der Kalibrierungstemperatursonde 60, 61 erfassten aktuellen Temperaturen an den verschiedenen Positionen.

In Schritt S7 erfolgt das Speichern der kalibrierten Temperaturausgabewerte der einen oder der mehreren Temperatursonden S1-S9 an den verschiedenen Positionen, beispielsweise in der Speichereinrichtung 310 des Temperaturcontrollers 300 und/oder im Probercontroller 700.

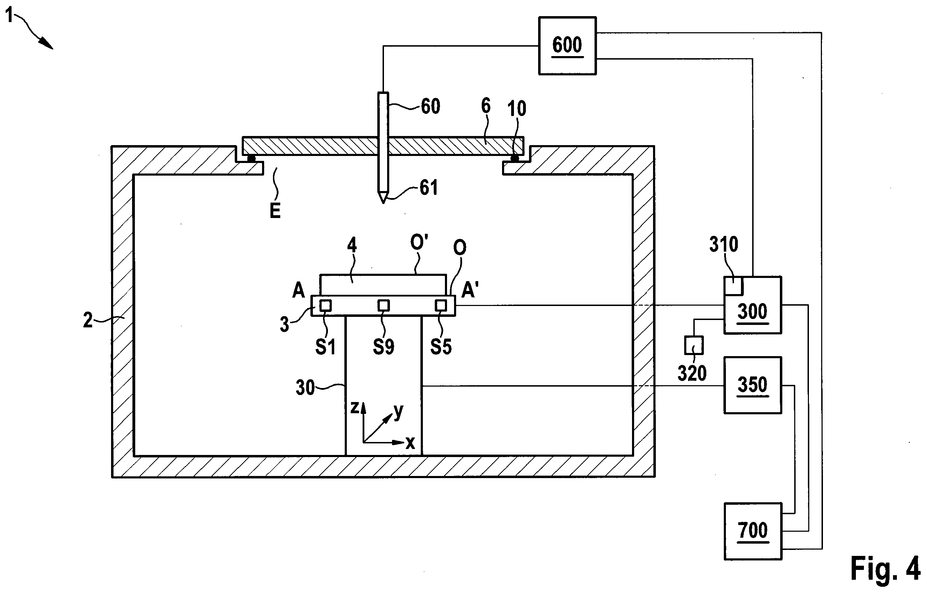

Fig. 4 zeigt eine Kalibrierungsanordnung gemäß einer dritten Ausführungsform der vorliegenden Erfindung im Ausgangszustand.

Die dritte Ausführungsform gemäß Fig. 4 unterscheidet sich von der ersten Ausführungsform dadurch, dass im Kalibrierungsmodus nicht die jeweiligen aktuellen Temperaturen an verschiedenen Positionen an der Oberfläche O des Chucks 3 ermittelt werden, sondern bei auf den Chuck 3 aufgespanntem Wafer 4 die jeweilige aktuelle Temperatur an verschiedenen Positionen an der Oberfläche O' des darauf aufgespannten Wafers 4 erfasst werden. Somit kann noch genauer die Temperatur an den zu testenden integrierten Schaltungen ermittelt werden, da ein möglicher Wärmeübergangswiderstand zwischen dem Chuck 3 und dem aufgelegten Wafer 4 berücksichtigt werden kann.

Ansonsten ist die dritte Ausführungsform analog zur ersten Ausführungsform ausgestaltet.

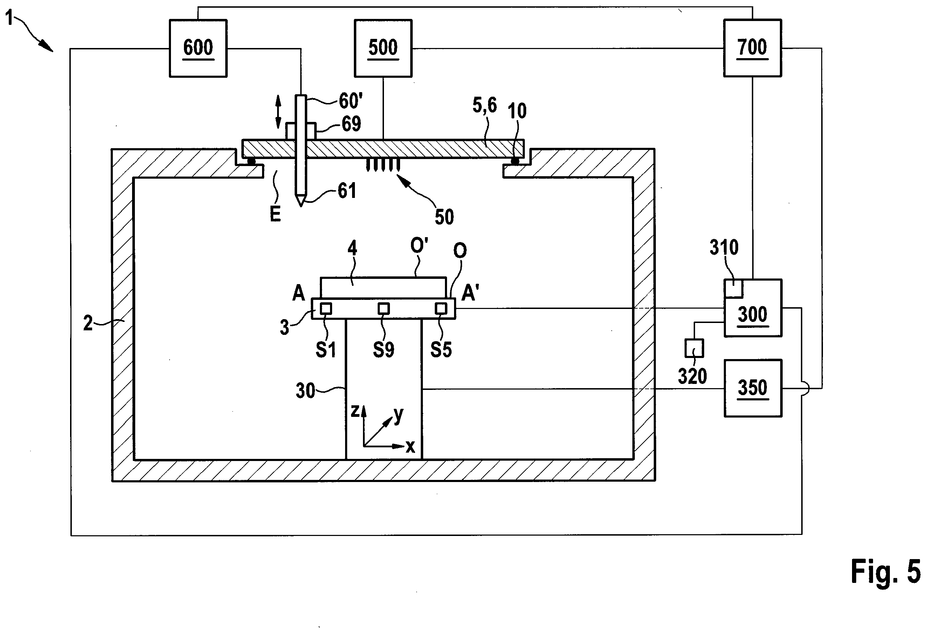

Fig. 5 zeigt eine Kalibrierungsanordnung gemäß einer vierten Ausführungsform der vorliegenden Erfindung im Ausgangszustand.

Bei der vierten Ausführungsform ist die Kalibrierungskarte 6 einteilig integriert mit der Testkarte 5 ausgebildet (mit anderen Worten darin integriert). Die Kalibrierungstemperatursonde 60', 61 weist bei dieser Ausführungsform einen durch die Kalibrierungskarte 6 bzw. Testkarte 5 höhenverstellbar geführten Schaft 60' auf. Eine entsprechende Höhenverstellung kann beispielsweise über eine Verstelleinrichtung 69 bewirkt werden. Die Höhenverstellbarkeit bewirkt, dass im Testmodus die Kalibrierungstemperatursonde 60', 61, welche analog zur ersten Ausführungsform aufgebaut ist, nicht mit den Testsonden 50 interferiert, sondern nach oben dahinter zurückgezogen ausgerichtet sein kann.

Diese Ausführungsform hat den besonderen Vorteil, dass kein Austausch von Testkarte 5 und Kalibrierungskarte 6 erforderlich ist, sondern lediglich eine Umschaltung vom Testmodus in den Kalibrierungsmodus durch den Probercontroller 700 erfolgen muss.

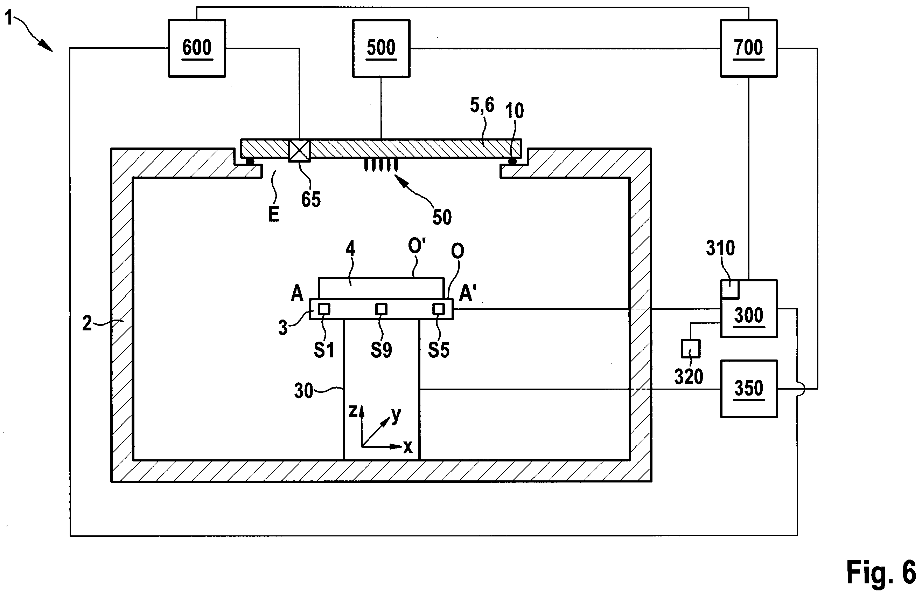

Fig. 6 zeigt eine Kalibrierungsanordnung gemäß einer fünften Ausführungsform der vorliegenden Erfindung im Ausgangszustand.

Bei der fünften Ausführungsform ist die Kalibrierungskarte 6 ebenfalls einteilig integriert in der Testkarte 5 ausgebildet, wobei die Kalibrierungstemperatursonde 65 bei dieser Ausführungsform ein kontaktloser Infrarotsensor 65 ist, welcher mit der Auswerteeinrichtung 600 verbunden ist. Dadurch lässt sich ein direkter Oberflächenkontakt mit der Oberfläche O' des Wafers 4 bzw. mit der Oberfläche O des Chucks 3 vermeiden, und eine Höhenverstellbarkeit wie bei der vierten Ausführungsform kann entfallen.

Dies erbringt den zusätzlichen Vorteil, dass auch in situ beim Testen eine Kalibrierung bzw. Temperaturerfassung mittels der Kalibrierungstemperatursonde 65 ermöglicht ist.

Ansonsten ist die fünfte Ausführungsform analog zur vierten Ausführungsform ausgestaltet.

Obwohl die vorliegende Erfindung vorstehend anhand bevorzugter Ausführungsformen erläutert wurde, ist sie nicht darauf beschränkt, sondern in vielfältiger Weise modifizierbar.

Insbesondere ist die Anzahl und Anordnung der Temperatursonden im Chuck und deren Art nur beispielhaft und nicht auf die dargestellten Beispiele beschränkt.

## Patentansprüche

1. Kalibrierungsanordnung zum Kalibrieren eines Chucks mit:
einem Waferprober (1) mit einer Einsetzöffnung (E) zum Einsetzen einer Testkarte (5) mit Testsonden (50) zum Testen von auf einem Wafer (4) befindlichen integrierten Schaltungen, wobei bei eingesetzter Testkarte (5) ein im Wesentlichen geschlossener Raum gebildet ist;
einem von einem Temperaturcontroller (300) auf eine eingebbare Solltemperatur temperierbaren Chuck (3) zum Aufspannen des Wafers (4), wobei der Chuck (3) mittels eines Positionscontrollers (350) über eine Verstelleinrichtung (30) in seitlichen Richtungen (x, y) und in Höhenrichtung (z) verfahrbar ist; und
einer im Chuck (3) angeordneten Temperaturerfassungseinrichtung mit einer oder mehreren Temperatursonden (S1-S9) zum Erfassen und Ausgeben einer jeweiligen aktuellen Chucktemperatur an der Position der jeweiligen Temperatursonde (S1-S9);
einer Kalibrierungsvorrichtung (6, 60, 61, 600), aufweisend:
eine in oder an der Einsetzöffnung (E) anbringbare Kalibrierungskarte (6), wobei bei angebrachter Kalibrierungskarte (6) ein entsprechender im Wesentlichen geschlossener Raum gebildet ist;
eine an der Kalibrierungskarte (6) angebrachte Kalibrierungstemperatursonde (60, 61; 60', 61; 65), welche vom Chuck (3) mittels des Positionscontrollers (350) über die Verstelleinrichtung (30) derart anfahrbar ist, dass die Kalibrierungstemperatursonde (60, 61; 60', 61; 65) eine jeweilige aktuelle Temperatur an verschiedenen Positionen an der Oberfläche (O) des Chucks (3) oder an der Oberfläche (O') eines darauf aufgespannten Wafers (4) erfassen kann; und
eine Auswerteeinrichtung (600), welche mit der Kalibrierungstemperatursonde (60, 61; 60', 61; 65), dem Temperaturcontroller (300) und dem Positionscontroller (350) verbunden ist und welche eingerichtet ist, die Temperaturausgabewerte der einen oder der mehreren Temperatursonden (S1-S9) anhand den von der Kalibrierungstemperatursonde (60, 61; 60', 61; 65) erfassten aktuellen Temperaturen an den verschiedenen Positionen zu kalibrieren.

2. Kalibrierungsanordnung nach Anspruch 1, wobei die Temperaturerfassungseinrichtung eine einzige Temperatursonde aufweist und wobei die die Auswerteeinrichtung (600) eingerichtet ist, die Temperaturausgabewerte der einzigen Temperatursonde anhand von der Kalibrierungstemperatursonde (60, 61; 60', 61; 65) erfassten aktuellen Temperaturen an den verschiedenen Positionen zu kalibrieren.

3. Kalibrierungsanordnung nach Anspruch 1, wobei die Temperaturerfassungseinrichtung mehrere Temperatursonden (S1-S9) aufweist, wobei jeder Temperatorsonde (S1-S9) ein Temperaturerfassungssektor (B1-B9) im Chuck (3) zugeordnet ist, für den sie die jeweilige aktuelle Chucktemperatur erfasst und ausgibt, und wobei die Auswerteeinrichtung (600) eingerichtet ist, die Temperaturausgabewerte der jeweiligen Temperatursonde (S1-S9) anhand der von der Kalibrierungstemperatursonde (60, 61; 60', 61; 65) erfassten aktuellen Temperaturen für den zugeordneten Temperaturerfassungssektor (B1-B9) zu kalibrieren.

4. Kalibrierungsanordnung nach einem der vorhergehenden Ansprüche, wobei der Temperaturcontroller (300) eine Speichereinrichtung (310) aufweist und wobei die Auswerteeinrichtung (600) eingerichtet ist, die kalibrierten Temperaturausgabewerte der einen oder der mehreren Temperatursonden (S1-S9) an den verschiedenen Positionen in der Speichereinrichtung (310) zu speichern.

5. Kalibrierungsanordnung nach einem der vorhergehenden Ansprüche, wobei der Temperaturcontroller (300) eine Ausgabeeinrichtung (320), insbesondere eine Anzeigeeinrichtung, zum Ausgeben der kalibrierten Temperaturausgabewerte der einen oder der mehreren Temperatursonden (S1-S9) an den verschiedenen Positionen aufweist.

6. Kalibrierungsanordnung nach einem der vorhergehenden Ansprüche, wobei die Kalibrierungstemperatursonde (60, 61; 60', 61; 65) einen durch die Kalibrierungskarte (6) geführten Schaft (60) aufweist, an dessen Ende ein Thermowiderstand (61), vorzugsweise ein Pt100-Thermowiderstand, angebracht ist.

7. Kalibrierungsanordnung nach einem der vorhergehenden Ansprüche, wobei die Kalibrierungstemperatursonde (60, 61; 60', 61; 65) einen kontaktlosen Infrarotsensor aufweist.

8. Kalibrierungsanordnung nach einem der vorhergehenden Ansprüche, wobei die Kalibrierungstemperatursonde (60, 61; 60', 61; 65) eine Messgenauigkeit im Bereich von 1 mK bis 10 mK aufweist, insbesondere im Bereich von 1 mK bis 5 mK, und/oder die Kalibrierungstemperatursonde (60, 61; 60', 61; 65) einen Flächenerfassungsbereich im Bereich 10 mm² bis 20 mm² aufweist.

9. Kalibrierungsanordnung nach einem der vorhergehenden Ansprüche, wobei der Temperaturcontroller (300) eingerichtet ist, die Solltemperatur mittels mindestens einer der kalibrierten Temperatursonden (S1-S9) zu regeln.

10. Kalibrierungsanordnung nach einem der vorhergehenden Ansprüche, wobei die Kalibrierungskarte (6) einteilig integriert mit der Testkarte (5) ausgebildet ist.

11. Kalibrierungsanordnung nach Anspruch 10, wobei die Kalibrierungstemperatursonde (60, 61; 60', 61; 65) einen höhenverstellbar durch die Kalibrierungskarte (6) geführten Schaft (60') aufweist.

12. Kalibrierungsverfahren zum Kalibrieren eines Chucks mit den Schritten:
Bereitstellen (S1) von einem Waferprober (1) mit einer Einsetzöffnung (E) zum Einsetzen einer Testkarte (5) mit Testsonden (50) zum Testen von auf einem Wafer (4) befindlichen integrierten Schaltungen, wobei bei eingesetzter Testkarte (5) ein im Wesentlichen geschlossener Raum gebildet ist;
Bereitstellen (S2) von einem von einem Temperaturcontroller (300) auf eine eingebbare Solltemperatur temperierbaren Chuck (3) zum Aufspannen des Wafers (4), wobei der Chuck (3) mittels eines Positionscontrollers (350) über eine Verstelleinrichtung (30) in seitlichen Richtungen (x, y) und in Höhenrichtung (z) verfahrbar ist; und
Bereitstellen (S3) von einer im Chuck (3) angeordneten Temperaturerfassungseinrichtung mit einer oder mehreren Temperatursonden (S1-S9) zum Erfassen und Ausgeben einer jeweiligen aktuellen Chucktemperatur an der Position der jeweiligen Temperatursonde (S1-S9);
Anbringen (S4) einer Kalibrierungskarte (6) in oder an der Einsetzöffnung (E), wobei bei angebrachter Kalibrierungskarte (6) ein entsprechender im Wesentlichen geschlossener Raum gebildet ist, wobei an der Kalibrierungskarte (6) eine Kalibrierungstemperatursonde (60, 61; 60', 61; 65) angebracht ist;
Anfahren (S5) der Kalibrierungstemperatursonde (60, 61; 60', 61; 65) vom Chuck (3) mittels des Positionscontrollers (350) über die Verstelleinrichtung (30) und Erfassen einer jeweiligen aktuellen Temperatur an verschiedenen Positionen an der Oberfläche (O) des Chucks (3) oder an der Oberfläche (O') eines darauf aufgespannten Wafers (4) mittels der Kalibrierungstemperatursonde (60, 61; 60', 61; 65); und
Kalibrieren (S6) der Temperaturausgabewerte der einen oder der mehreren Temperatursonden (S1-S9) anhand den von der Kalibrierungstemperatursonde (60, 61; 60', 61; 65) erfassten aktuellen Temperaturen an den verschiedenen Positionen.

13. Kalibrierungsverfahren nach Anspruch 12, wobei ein Speichern (S7) der kalibrierten Temperaturausgabewerte der einen oder der mehreren Temperatursonden (S1-S9) an den verschiedenen Positionen erfolgt.

14. Kalibrierungsverfahren nach Anspruch 12 oder 13, wobei die Solltemperatur mittels mindestens einer der kalibrierten Temperatursonden (S1-S9) geregelt wird.

## Claims

1. Calibration arrangement for calibrating a chuck with:
a wafer prober (1) with an insertion opening (E) for inserting a test card (5) with test probes (50) for testing integrated circuits located on a wafer (4), wherein a substantially closed space is formed when the test card (5) is inserted;
a chuck (3) for clamping the wafer (4) which can be temperature-controlled by a temperature controller (300) to a setpoint temperature that can be entered, wherein the chuck (3) can be displaced in lateral directions (x, y) and in a vertical direction (z) by means of a position controller (350) via an adjustment device (30); and
a temperature detection device arranged in the chuck (3) and having one or more temperature probes (S1-S9) for detecting and outputting a respective current chuck temperature at the position of the respective temperature probe (S1-S9);
a calibration device (6, 60, 61, 600), having:
a calibration card (6) which can be mounted in or on the insertion opening (E), wherein a corresponding substantially closed space is formed when the calibration card (6) is mounted;
a calibration temperature probe (60, 61; 60', 61; 65) which is mounted on the calibration card (6) and which can be approached by the chuck (3) by means of the position controller (350) via the adjustment device (30) in such a way that the calibration temperature probe (60, 61; 60', 61; 65) can detect a respective current temperature at various positions on the surface (O) of the chuck (3) or on the surface (O') of a wafer (4) mounted thereon; and
an evaluation device (600), which is connected to the calibration temperature probe (60, 61; 60', 61; 65), the temperature controller (300) and the position controller (350) and which is designed to calibrate the temperature output values of the one or more temperature probes (S1-S9) based on the current temperatures detected by the calibration temperature probe (60, 61; 60', 61; 65) at the various positions.

2. Calibration arrangement according to claim 1, wherein the temperature detection device has a single temperature probe and wherein the evaluation device (600) is designed to calibrate the temperature output values of the single temperature probe based on current temperatures detected by the calibration temperature probe (60, 61; 60', 61; 65) at the various positions.

3. Calibration arrangement according to claim 1, wherein the temperature detection device has a plurality of temperature probes (S1-S9), wherein each temperature probe (S1-S9) is associated with a temperature detection sector (B1-B9) in the chuck (3) for which it detects and outputs the respective current chuck temperature, and wherein the evaluation device (600) is designed to calibrate the temperature output values of the respective temperature probe (S1-S9) based on the current temperatures detected by the calibration temperature probe (60, 61; 60', 61; 65) for the associated temperature detection sector (B1-B9).

4. Calibration arrangement according to one of the preceding claims, wherein the temperature controller (300) has a storage device (310) and wherein the evaluation device (600) is designed to store the calibrated temperature output values of the one or more temperature probes (S1-S9) at the various positions in the storage device (310).

5. Calibration arrangement according to one of the preceding claims, wherein the temperature controller (300) has an output device (320), in particular a display device, for outputting the calibrated temperature output values of the one or more temperature probes (S1-S9) at the various positions.

6. Calibration arrangement according to one of the preceding claims, wherein the calibration temperature probe (60, 61; 60', 61; 65) has a shaft (60) passing through the calibration card (6) on the end of which a thermal resistor (61), preferably a Pt100 thermal resistor, is mounted.

7. Calibration arrangement according to one of the preceding claims, wherein the calibration temperature probe (60, 61; 60', 61; 65) has a contactless infrared sensor.

8. Calibration arrangement according to one of the preceding claims, wherein the calibration temperature probe (60, 61; 60', 61; 65) has a measurement accuracy in the range of 1 mK to 10 mK, in particular in the range of 1 mK to 5 mK, and/or the calibration temperature probe (60, 61; 60', 61; 65) has an area detection range in the range of 10 mm² to 20 mm².

9. Calibration arrangement according to one of the preceding claims, wherein the temperature controller (300) is designed to control the setpoint temperature by means of at least one of the calibrated temperature probes (S1-S9).

10. Calibration arrangement according to one of the preceding claims, wherein the calibration card (6) is formed integrally integrated with the test card (5).

11. Calibration arrangement according to claim 10, wherein the calibration temperature probe (60, 61; 60', 61; 65) has a shaft (60') passing through the calibration card (6) in a height-adjustable manner.

12. Calibration method for calibrating a chuck with the steps of:
providing (S1) a wafer prober (1) with an insertion opening (E) for inserting a test card (5) with test probes (50) for testing integrated circuits located on a wafer (4), wherein a substantially closed space is formed when the test card (5) is inserted;
providing (S2) a chuck (3) for clamping the wafer (4) which can be temperature-controlled by a temperature controller (300) to a setpoint temperature that can be entered, wherein the chuck (3) can be displaced in lateral directions (x, y) and in a vertical direction (z) by means of a position controller (350) via an adjustment device (30); and
providing (S3) a temperature detection device arranged in the chuck (3) and having one or more temperature probes (S1-S9) for detecting and outputting a respective current chuck temperature at the position of the respective temperature probe (S1-S9);
mounting (S4) a calibration card (6) in or on the insertion opening (E), wherein a corresponding substantially closed space is formed when the calibration card (6) is mounted, wherein a calibration temperature probe (60, 61; 60', 61; 65) is mounted on the calibration card (6);
approaching (S5) the calibration temperature probe (60, 61; 60', 61; 65) by the chuck (3) by means of the position controller (350) via the adjustment device (30) and detecting a respective current temperature at various positions on the surface (O) of the chuck (3) or on the surface (O') of a wafer (4) mounted thereon by means of the calibration temperature probe (60, 61; 60', 61; 65); and
calibrating (S6) the temperature output values of the one or more temperature probes (S1-S9) based on the current temperatures detected by the calibration temperature probe (60, 61; 60', 61; 65) at the various positions.

13. Calibration method according to claim 12, wherein the calibrated temperature output values of the one or more temperature probes (S1-S9) at the various positions are stored (S7).

14. Calibration method according to claim 12 or 13, wherein the setpoint temperature is controlled by means of at least one of the calibrated temperature probes (S1-S9).

## Revendications

1. Agencement d'étalonnage pour étalonner un support de plaquette, comportant :
un testeur de plaquettes (1) comportant une ouverture d'insertion (E) pour insérer une carte de test (5) avec des sondes de test (50) pour tester des circuits intégrés situés sur une plaquette (4), un espace essentiellement fermé étant formé lorsque la carte de test (5) est insérée ;
un support de plaquette (3) pour serrer la plaquette (4), qui peut être mis à une température de consigne pouvant être entrée par un régulateur de température (300), le support de plaquette (3) pouvant être déplacé dans des directions latérales (x, y) et dans la direction verticale (z) au moyen d'un régulateur de position (350) via un dispositif de réglage (30) ; et
un dispositif de détection de température disposé dans le support de plaquette (3) avec une ou plusieurs sondes de température (S1-S9) pour détecter et délivrer une température actuelle respective du support de plaquette à la position de la sonde de température respective (S1-S9) ;
un dispositif d'étalonnage (6, 60, 61, 600) présentant :
une carte d'étalonnage (6) pouvant être montée dans ou sur l'ouverture d'insertion (E), un espace essentiellement fermé correspondant étant formé lorsque la carte d'étalonnage (6) est montée ;
une sonde de température d'étalonnage (60, 61 ; 60', 61 ; 65) montée sur la carte d'étalonnage (6), qui peut être approchée du support de plaquette (3) au moyen du régulateur de position (350) via le dispositif de réglage (30) de telle sorte que la sonde de température d'étalonnage (60, 61 ; 60', 61 ; 65) puisse détecter une température actuelle respective à différentes positions sur la surface (O) du support de plaquette (3) ou sur la surface (O') d'une plaquette (4) serrée sur celui-ci ; et
un dispositif d'évaluation (600) qui est relié à la sonde de température d'étalonnage (60, 61 ; 60', 61 ; 65), au régulateur de température (300) et au régulateur de position (350) et qui est conçu pour étalonner les valeurs de sortie de température desdites une ou plusieurs sondes de température (S1-S9) à l'aide des températures actuelles détectées par la sonde de température d'étalonnage (60, 61 ; 60', 61 ; 65) aux différentes positions.

2. Dispositif d'étalonnage selon la revendication 1, dans lequel le dispositif de détection de température présente une seule sonde de température et dans lequel le dispositif d'évaluation (600) est conçu pour étalonner les valeurs de sortie de température de la seule sonde de température à l'aide des températures actuelles détectées par la sonde de température d'étalonnage (60, 61 ; 60', 61 ; 65) aux différentes positions.

3. Dispositif d'étalonnage selon la revendication 1, dans lequel le dispositif de détection de température présente plusieurs sondes de température (S1-S9), chaque sonde de température (S1-S9) étant associée à un secteur de détection de température (B1-B9) dans le support de plaquette (3), pour lequel il détecte et délivre la température actuelle respective du support de plaquette, et dans lequel le dispositif d'évaluation (600) est conçu pour étalonner les valeurs de sortie de température de la sonde de température respective (S1-S9) à l'aide des températures actuelles détectées par la sonde de température d'étalonnage (60, 61 ; 60', 61 ; 65) pour le secteur de détection de température associé (B1-B9).

4. Dispositif d'étalonnage selon l'une des revendications précédentes, dans lequel le régulateur de température (300) présente un dispositif de mémoire (310) et le dispositif d'évaluation (600) est conçu pour mémoriser les valeurs de sortie de température étalonnées desdites une ou plusieurs sondes de température (S1-S9) aux différentes positions dans le dispositif de mémoire (310).

5. Dispositif d'étalonnage selon l'une des revendications précédentes, dans lequel le régulateur de température (300) présente un dispositif de sortie (320), en particulier un dispositif d'affichage, pour délivrer les valeurs de sortie de température étalonnées desdites une ou plusieurs sondes de température (S1-S9) aux différentes positions.

6. Dispositif d'étalonnage selon l'une des revendications précédentes, dans lequel la sonde de température d'étalonnage (60, 61 ; 60', 61 ; 65) présente une tige (60) guidée par la carte d'étalonnage (6), à l'extrémité de laquelle est fixée une thermistance (61), de préférence une thermistance Pt100.

7. Dispositif d'étalonnage selon l'une des revendications précédentes, dans lequel la sonde de température d'étalonnage (60, 61 ; 60', 61 ; 65) présente un capteur infrarouge sans contact.

8. Dispositif d'étalonnage selon l'une des revendications précédentes, dans lequel la sonde de température d'étalonnage (60, 61 ; 60', 61 ; 65) présente une précision de mesure dans la plage de 1 mK à 10 mK, en particulier dans la plage de 1 mK à 5 mK, et/ou la sonde de température d'étalonnage (60, 61 ; 60', 61 ; 65) présente une plage de détection de surface dans la plage de 10 mm² à 20 mm².

9. Dispositif d'étalonnage selon l'une des revendications précédentes, dans lequel le régulateur de température (300) est conçu pour réguler la température de consigne à l'aide d'au moins une des sondes de température étalonnées (S1-S9).

10. Dispositif d'étalonnage selon l'une des revendications précédentes, dans lequel la carte d'étalonnage (6) est intégrée d'un seul tenant à la carte de test (5).

11. Dispositif d'étalonnage selon la revendication 10, dans lequel la sonde de température d'étalonnage (60, 61 ; 60', 61 ; 65) présente une tige (60') guidée de manière réglable en hauteur par la carte d'étalonnage (6).

12. Procédé d'étalonnage pour étalonner un support de plaquette, comprenant les étapes suivantes :
mise à disposition (S1) d'un testeur de plaquettes (1) comportant une ouverture d'insertion (E) pour insérer une carte de test (5) avec des sondes de test (50) pour tester des circuits intégrés situés sur une plaquette (4), un espace essentiellement fermé étant formé lorsque la carte de test (5) est insérée ;
mise à disposition (S2) d'un support de plaquette (3) pour serrer la plaquette (4), qui peut être mis à une température de consigne pouvant être entrée par un régulateur de température (300), le support de plaquette (3) pouvant être déplacé dans des directions latérales (x, y) et dans la direction verticale (z) au moyen d'un régulateur de position (350) via un dispositif de réglage (30) ; et
mise à disposition (S3) d'un dispositif de détection de température disposé dans le support de plaquette (3) avec une ou plusieurs sondes de température (S1-S9) pour détecter et délivrer une température actuelle respective du support de plaquette à la position de la sonde de température respective (S1-S9) ;
montage (S4) d'une carte d'étalonnage (6) dans ou sur l'ouverture d'insertion (E), un espace essentiellement fermé correspondant étant formé lorsque la carte d'étalonnage (6) est montée, une sonde de température d'étalonnage (60, 61 ; 60', 61 ; 65) étant montée sur la carte d'étalonnage (6) ;
approche (S5) de la sonde de température d'étalonnage (60, 61 ; 60', 61 ; 65) du support de plaquette (3) au moyen du régulateur de position (350) via le dispositif de réglage (30) et détection d'une température actuelle respective à différentes positions sur la surface (O) du support de plaquette (3) ou sur la surface (O') d'une plaquette (4) serrée sur celui-ci au moyen de la sonde de température d'étalonnage (60, 61 ; 60', 61 ; 65) ; et
étalonnage (S6) des valeurs de sortie de température desdites une ou plusieurs sondes de température (S1-S9) à l'aide des températures actuelles détectées par la sonde de température d'étalonnage (60, 61 ; 60', 61 ; 65) aux différentes positions.

13. Procédé d'étalonnage selon la revendication 12, dans lequel les valeurs de sortie de température étalonnées desdites une ou plusieurs sondes de température (S1-S9) aux différentes positions sont mémorisées (S7).

14. Procédé d'étalonnage selon la revendication 12 ou 13, dans lequel la température de consigne est régulée au moyen d'au moins une des sondes de température étalonnées (S1-S9).
